# EUROPÄISCHE PATENTSCHRIFT

(11) **EP 0 813 804 B1**
(45) Veröffentlichungstag und Bekanntmachung des Hinweises auf die Patenterteilung: **16.12.1998**
(21) Anmeldenummer: 96905730.6
(22) Anmeldetag: 05.03.1996
(51) Int. Cl.: H05K 7/14

(54) **GERÄT DER KOMMUNIKATIONSMESSTECHNIK**
COMMUNICATIONS AND MEASUREMENT APPARATUS
APPAREIL DE COMMUNICATIONS ET DE MESURE

(30) Priorität: 07.03.1995 DE 19509690
(43) Veröffentlichungstag der Anmeldung: 29.12.1997
(73) Patentinhaber: TEKTRONIX, INC., Wilsonville, Oregon 97070-1000 (US)
(72) Erfinder: HOFFMANN, Olaf, D-10589 Berlin (DE); MERZ, Rudolf, D-10713 Berlin (DE); NESS, Christian, D-13189 Berlin (DE); PACK, Reinhard, D-12159 Berlin (DE)
(74) Vertreter: Strasse, Joachim, Dipl.-Ing.
(86) Internationale Anmeldenummer: DE9600457
(87) Internationale Veröffentlichungsnummer: WO9628003

(56) Entgegenhaltungen:
- EP-A- 0 493 214
- WO-A-84/00829
- FR-A- 2 587 576
- US-A- 4 337 499

## Beschreibung

Die Erfindung bezieht sich auf ein Gerät der Kommunikationsmeßtechnik mit einem quaderförmigen Gehäuse, das an seiner Frontseite eine Anzeigeeinheit und an seiner Rückseite mehrere nebeneinanderliegende Aufnahmeöffnungen für Einschübe aufweist, von denen mindestens ein Einschub ein Datenverarbeitungseinschub ist, und das mit weiteren Einschüben zur Bildung äußerer Schnittstellen für Meß- und Datenleitungen ausgerüstet ist.

Bei einem bekannten Gerät dieser Art (Prospekt DA-058-01-A4 "interWATCH 95000" der Firma GN Navtel vom September 1994) sind an der Rückseite des Gerätes drei Aufnahmeöffnungen vorgesehen; eine Aufnahmeöffnung dient zur Unterbringung eines Datenverarbeitungseinschubes, während eine weitere Aufnahmeöffnung zum Einbringen eines Einschubs zur Verbindung mit einem Local Area Network dient. Eine dritte Aufnahmeöffnung an der Rückseite des bekannten Gerätes ist zur Aufnahme von parallelen oder seriellen Anordnungen und/oder zur Aufnahme des Anschlusses für einen VGA-Monitor vorbereitet. Weitere Einschübe weist das bekannte Gerät an seiner Gehäuseoberseite auf, indem dort acht Aufnahmeöffnungen zum Einbringen von acht Einschüben vorgesehen sind. Bei diesen Einschüben handelt es sich um Einschübe zur Bildung äußerer Schnittstellen für Meß- und Datenleitungen.

Der Erfindung liegt die Aufgabe zugrunde, ein Gerät der Kommunikationstechnik vorzuschlagen, das sich nicht nur durch einen kompakten Aufbau, sondern auch durch eine günstige Handhabbarkeit auszeichnet.

Zur Lösung dieser Aufgabe sind bei einem Gerät der Kommunikationsmeßtechnik der eingangs angegebenen Art sämtliche weiteren Einschübe in entsprechend vielen Aufnahmeöffnungen auf der Rückseite des Gerätes neben dem Datenverarbeitungseinschub auf einer Seite dieses Einschubes angeordnet; ein zusätzlicher Einschub mit einer Systemsteuerung ist zwischen den weiteren Einschüben und dem Datenverarbeitungseinschub in der Weise angeordnet, daß er mit seiner Bauelemente tragenden Seite diesem Datenverarbeitungseinschub zugewandt ist, und sämtliche weiteren Einschübe und der zusätzliche Einschub weisen eine gemeinsame Rückwandplatine auf.

Ein wesentlicher Vorteil des erfindungsgemäßen Gerätes wird darin gesehen, daß es durch die Anordnung sämtlicher Einschübe auf der Rückseite möglich ist, das Gerät in Gestelle einzubauen. Bei einem solchen Einbau bleibt das Gerät von vorne und hinten zugänglich, jedoch ist eine Zugriffmöglichkeit zur Oberseite nicht möglich; dem trägt das erfindungsgemäße Gerät Rechnung, indem es auf seiner Oberseite geschlossen ist und an der Rückseite sämtliche weiteren Einschübe aufweist. Das erfindungsgemäße Gerät ist deshalb zusammen mit anderen Geräten auch stapelbar. Ein weiterer wesentlicher Vorteil wird darin gesehen, daß das Gerät einen kompakten Aufbau aufgrund der Anordnung der Einschübe nebeneinander aufweist, weil dadurch die Möglichkeit einer guten Belüftung besteht. Dies ist darauf zurückzuführen, daß bei dem erfindungsgemäßen Gerät eine (relativ großflächige) innere Rückwandplatine der weiteren Einschübe und des zusätzlichen Einschubs senkrecht im Gerät verläuft und dadurch die Konvektion der Luft nicht behindert. Der kompakte Aufbau wird zusätzlich durch die spezielle Anordnung des zusätzlichen Einschubs gefordert, die ein Herumführen der elektrischen Verbindungsleitung zum Datenverarbeitungseinschub um den zusätzlichen Einschub bzw. die Rückwandplatine herum nicht erforderlich macht.

Bei dem erfindungsgemäßen Gerät ist der zusätzliche Einschub vorteilhafterweise über eine an seiner Bauelemente tragenden Seite angeordnete Steckverbindung und ein kurzes Leitungsstück mit der Rückwandplatine des Datenverarbeitungseinschubs verbunden. Damit läßt sich eine besonders einfache elektrische Verbindung zwischen dem zusätzlichen Einschub und der Rückwandplatine des Datenverarbeitungseinschubs herstellen.

Bei dem erfindungsgemäßen Gerät ist vorteilhafterweise unterhalb der Einschübe eine Lüfteranordnung untergebracht. Dadurch wird die natürliche Konvektion durch eine Druckbelüftung verstärkt, die bei dem erfindungsgemäßen Gerät deshalb besonders wirkungsvoll ist, weil die relativ große Rückwandplatine der weiteren Einschübe und des zusätzlichen Einschubs die Luftzirkulation nicht behindert.

Zur Erläuterung der Erfindung ist in
- Figur 1: eine perspektivische Darstellung eines Ausführungsbeispiels des erfindungsgemäßen Gerätes aus einer Sicht von schräg vorn, in
- Figur 2: eine perspektivische Darstellung desselben Ausführungsbeispiels aus einer Sicht von schräg hinten, in
- Figur 3: eine mit der Figur 2 übereinstimmende Darstellung, jedoch unter Fortlassung einiger weiterer Einschübe und in
- Figur 4: eine perspektivische Darstellung desselben Ausführungsbeispiels bei abgenommenem Gehäuse wiedergegeben.

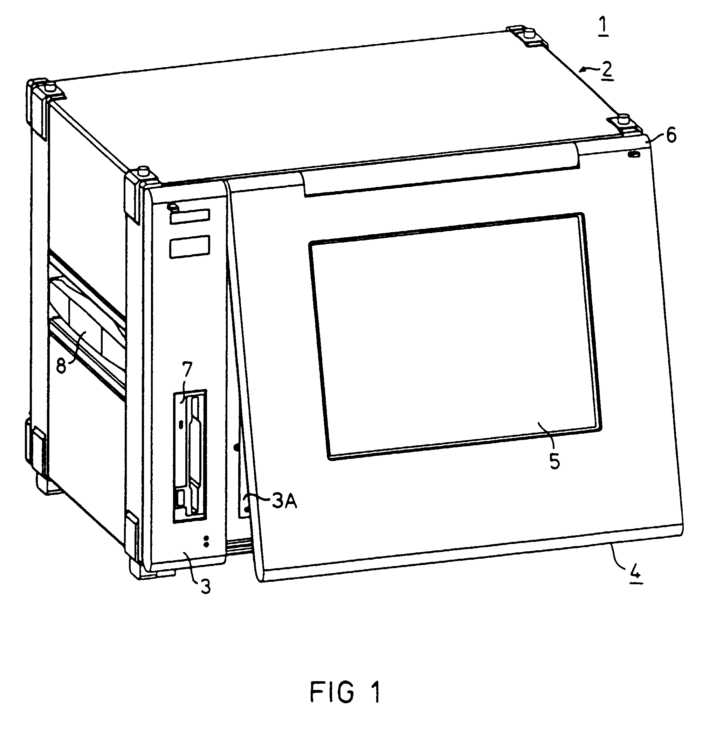

Wie die Figur 1 erkennen läßt, besitzt das erfindungsgemäße Gerät 1 ein quaderförmiges Gehäuse 2, das an seiner Frontseite 3 eine Anzeigeeinheit 4 mit einem LCD-Display 5 aufweist. Die Anzeigeeinheit 4 ist um ihre Oberkante 6 schwenkbar und gibt im herausgeschwenkten Zustand eine Abdeckplatte 3A an der Frontseite frei. Außerdem ist an der Frontseite 3 eine Aufnahmeöffnung 7 für eine Diskette vorgesehen. Seitlich ist an dem Gehäuse 2 jeweils ein Traggriff befestigt, von denen in der Fig. 1 ein Traggriff 8 erkennbar ist.

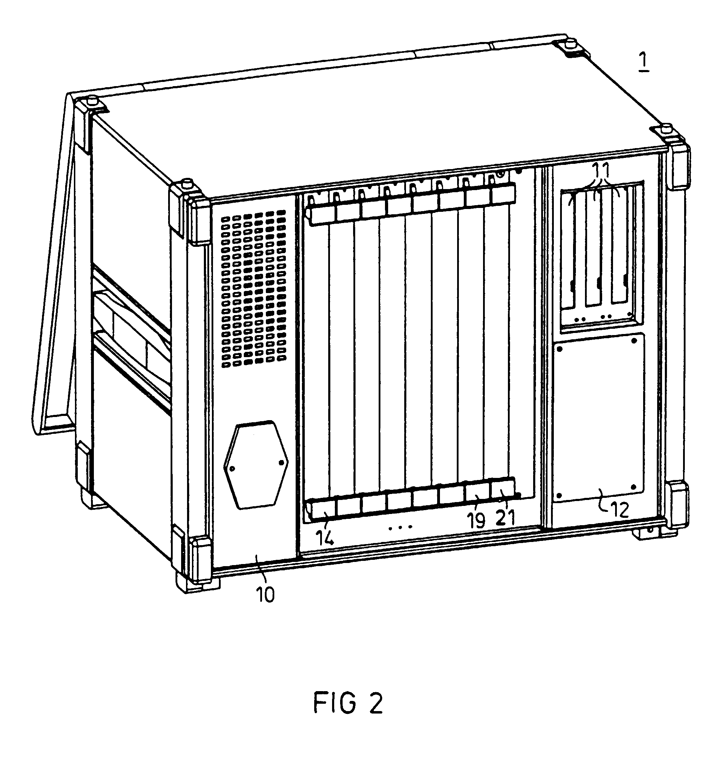

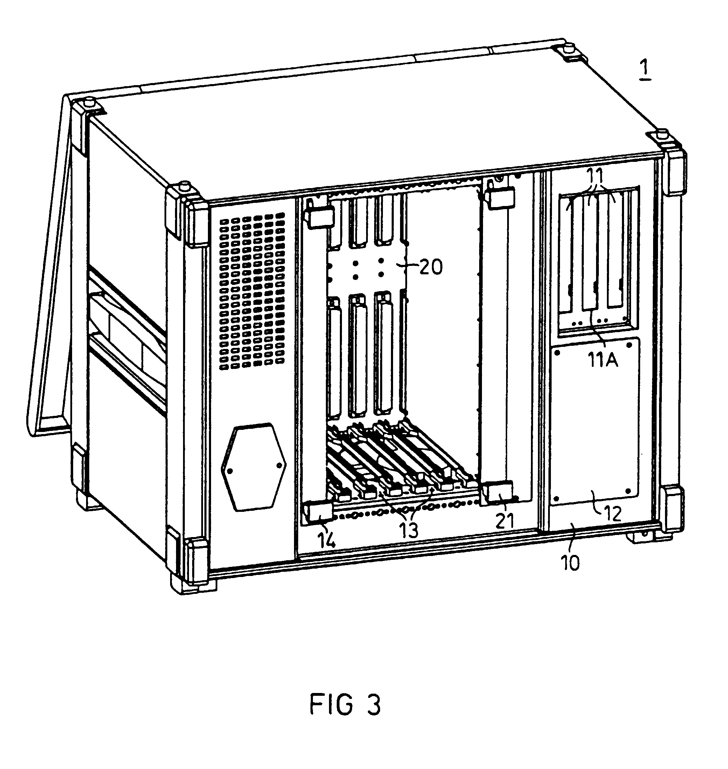

Den Figuren 2 und 3 läßt sich entnehmen, daß an der Rückseite 10 im rechten oberen Bereich mehrere Einschubkarten 11 vorgesehen sind, die in in den Figuren 2 und 3 nicht erkennbaren Aufnahmeöffnungen in der Rückwand eingeführt sind; diese Einschubkarten 11 bilden einen Datenverarbeitungseinschub 11A und können von Einschubkarten eines handelsüblichen Personal Computers gebildet sein. Unterhalb der Einschubkarten 11 ist in der Rückwand 10 eine weitere Öffnung vorgesehen, in die ein Massespeicher 12 eingebracht ist.

Die Figuren 2 und 3 lassen ferner erkennen, daß an der Rückseite 10 des Gerätes 1 weitere Aufnahmeöffnungen 13 vorgesehen sind, in die weitere Einschübe 14 bis 19 einbringbar sind. Bei den weiteren Einschüben 14 bis 19 handelt es sich um Einschübe, die äußere Schnittstellen für Meß- und Datenleitungen bilden. In der Figur 3 ist nur ein weiterer Einschub 14 gezeigt, um einen Blick auf eine innere Rückwandplatine 20 zu ermöglichen.

Die Rückwandplatine 20 weist auf ihrer zur Frontseite zeigenden Seite nicht gezeigte Stecker auf, die bei abgenommener Abdeckplatte 3A frei zugänglich sind. Mittels dieser Stecker können unter Zuhilfenahme zusätzlich aufgesteckter Platinen zusätzliche Funktionen realisiert werden.

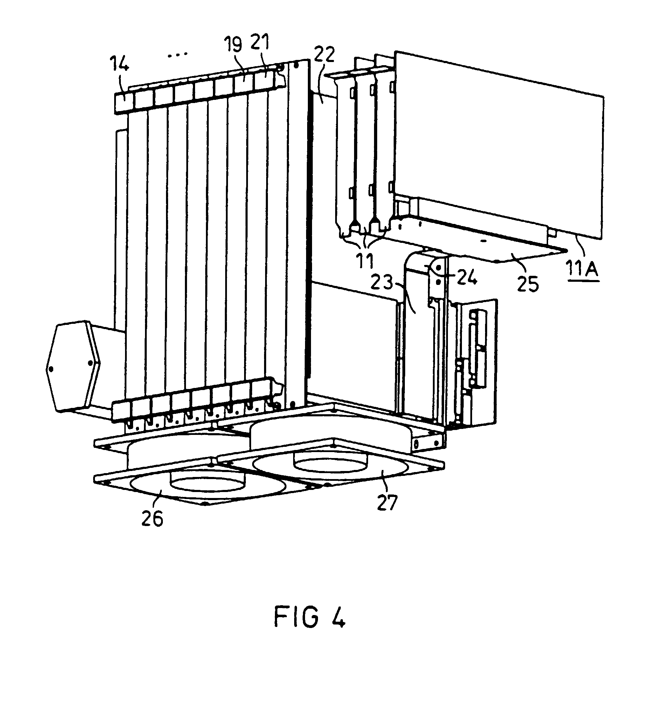

Ebenfalls den Figuren 2 und 3 ist entnehmbar, daß in die in den Figuren ganz rechte Aufnahmeöffnung der weiteren Aufnahmeöffnungen 13 ein zusätzlicher Einschub 21 eingebracht ist, bei dem es sich um einen Einschub zur Systemsteuerung handelt; dieser zusätzliche Einschub 21 ist vorteilhafterweise mit einem Systemsteuerungsprozessor ausgerüstet. Der zusätzliche Einschub 21 ist dicht neben dem Datenverarbeitungseinschüben 11A angeordnet, um ohne großen konstruktiven Aufwand und ohne zusätzlichen Platzbedarf eine elektrische Verbindung zwischen dem zusätzlichen Einschub 21 und dem Datenverarbeitungseinschub 11A zu erreichen. Näheres dazu ist der Figur 4 zu entnehmen.

In der Figur 4 ist wiederum der zusätzliche Einschub 21 zu erkennen, der im dargestellten Ausführungsbeispiel mit einer Leiterplatte 22 versehen ist. Auf dieser Leiterplatte 22 befinden sich auf der dem Betrachter zugewandten Seite Bauelemente, die der besseren Übersichtlichkeit halber in der Figur 4 nicht dargestellt sind. Hier befindet sich ferner eine Steckeinrichtung 23, von der als kurzes Leitungsstück eine flexible Leitung 24 an eine waagerecht unterhalb des weiteren Datenverarbeitungseinschubs 11A verlaufende Rückwandplatine 25 geführt ist. Damit ist eine elektrische Verbindung zwischen dem zusätzlichen Einschub 21 und dem Datenverarbeitungseinschub 11A hergestellt, ohne daß zur Bewerkstelligung dieser elektrischen Verbindung an dem zusätzlichen Einschub eine Leitung oben, unten oder hinten vorbeigeführt werden muß. Die Anordnung des zusätzlichen Einschubs 21 trägt wesentlich zur kompakten Bauform des erfindungsgemäßen Gerätes bei.

Ergänzend ist darauf hinzuweisen, daß sich unterhalb der Einschübe bei dem dargestellten Ausführungsbeispiel zwei Lüfter 26 und 27 befinden, von denen Luft nach Filterung zwischen den Einschüben 14 bis 19 sowie 21 unter Bewirkung einer guten Kühlung bewegt wird.

## Patentansprüche

1. Gerät der Kommunikationsmeßtechnik mit einem quaderförmigen Gehäuse, das
- an seiner Frontseite eine Anzeigeeinheit und an seiner Rückseite mehrere nebeneinander liegende Aufnahmeöffnungen für Einschübe aufweist, von denen mindestens ein Einschub ein Datenverarbeitungseinschub ist, und
- das mit weiteren Einschüben zur Bildung äußerer Schnittstellen für Meß- und Datenleitungen ausgerüstet ist,
**dadurch gekennzeichnet**, daß
- sämtliche weiteren Einschübe (14 bis 19) in entsprechend vielen Aufnahmeöffnungen (13) auf der Rückseite (10) des Gerätes (1) neben dem Datenverarbeitungseinschub (11A) auf einer Seite dieses Einschubs (llA) angeordnet sind,
- ein zusätzlicher Einschub (21) mit einer Systemsteuerung zwischen den weiteren Einschüben (14 bis 19) und dem Datenverarbeitungseinschub (llA) in der Weise angeordnet ist, daß er mit seiner Bauelemente tragenden Seite diesem Datenverarbeitungseinschub (llA) zugewandt ist und daß
- sämtliche weiteren Einschübe (14 bis 19) und der zusätzliche Einschub (21) eine gemeinsame Rückwandplatine (20) aufweisen.

2. Gerät nach Anspruch 1,
**dadurch gekennzeichnet**, daß
- die gemeinsame Rückwandplatine (20) der weiteren Einschübe (14 bis 19) und des zusätzlichen Einschubs (21) auf ihrer der Frontseite (3) des Gerätes (1) zugewandten Seite mit Steckern versehen ist, die unmittelbar hinter einer abnehmbaren Abdeckplatte (3A) der Frontseite (3) liegen.

3. Gerät nach Anspruch 1 oder 2,
**dadurch gekennzeichnet**, daß
- der zusätzliche Einschub (21) über eine Steckverbindung (23) und ein kurzes Leitungsstück (24) mit der Rückwandplatine (25) des Datenverarbeitungeinschubs (11A) verbunden ist.

4. Gerät nach einem der vorangehenden Ansprüche,
**dadurch gekennzeichnet**, daß
- unterhalb der Einschübe (11A; 14 bis 19; 21) eine Lüfteranordnung (26, 27) untergebracht ist.

## Claims

1. A communications and measurement apparatus having a parallelepiped-shaped casing
- comprising a display unit at its front side, as well as a plurality of adjacent apertures for accommodating plug-in units therein at its rear side, with at least one plug-in unit thereof being one for data processing, and
- including further plug-in units for forming external interfaces for test and data lines,
wherein
- all further plug-in units (14 to 19) are accommodated in a corresponding number of accommodation apertures (13) at the rear side (10) of said apparatus (1) next to and on one side of said data processing plug-in unit (11A),
- an additional plug-in unit (21) with a system controller is provided between said further plug-in units (14 to 19) and said data processing plug-in unit (11A) in such a manner that its components supporting side faces said data processing plug-in unit (11A), and
- all further plug-in units (14 to 19) as well as said additional plug-in unit (21) have a common back-panel board (20) .

2. The apparatus as claimed in claim 1, wherein
- said common back-panel board (20) of said further plug-in units (14 to 19) and said additional plug-in unit (21) includes plugs on its side facing the front side (3) of said apparatus (1), said plugs being located directly behind a detachable cover plate (3A) of the front side (3).

3. The apparatus as claimed in claims 1 or 2, wherein
- said additional plug-in unit (21) is connected to said back-panel board (25) of said data processing plug-in unit (11A) via a plug-type connector (23) and a short line piece (24) .

4. The apparatus as claimed in one of the preceding claims, wherein
- a fan arrangement (26, 27) is accommodated below said plug-in units (11A; 14 to 19; 21).

## Revendications

1. Appareil de communications et de mesure à bâti rectangulaire
- présentant côté frontal une unité d'affichage et côté dorsal plusieurs ouvertures d'accès côte à côte pour unités enfichables, dont au moins une est une unité de traitement de données, et
- étant équipé d'unités auxiliaires pour la création d'interfaces externes pour circuits de mesures et de données,
**caractérisé en ce que**
- toutes les unités auxiliaires (14 à 19) sont enfichés dans respectivement autant d'ouvertures (13) sur la partie dorsale (10) de l'appareil (1) à côté de l'unité de traitement de données (11A) et sur un côté uniquement de cette unité de traitement (11A),
- une unité supplémentaire (21) avec gestion des systèmes est placée entre les unités auxiliaires (14 à 19) et l'unité de traitement de données (11A), de sorte à ce que la partie portant les composants électroniques soit tourné vers l'unité de traitement de données (11A) et que
- toutes les unités auxiliaires (14 à 19) ainsi que l'unité supplémentaire (21) présentent une plaque arrière (20) commune.

2. Appareil suivant la revendication 1,
**caractérisé en ce que**
- la plaque arrière commune (20) des unités auxiliaires (14 à 19) et de l'unité supplémentaire (21) présente sur sa partie tournée vers le côté frontal (3) de l'appareil (1) des connecteurs situés directement derrière une plage de protection (3A) amovible de la partie frontale (3).

3. Appareil suivant les revendications 1 ou 2,
**caractérisé en ce que**
- l'unité supplémentaire (21) est connectée à la plaque arrière (25) de l'unité de traitement de données (11A) par un connecteur (23) et une courte ligne de circuit (24).

4. Appareil suivant l'une des revendications précédentes,
**caractérisé en ce que**
- un système de ventilation (26, 27) est installé sous les unités (11A; 14 à 19; 21).
